# EUROPEAN PATENT APPLICATION

(11) **EP 4 697 378 A1**
(43) Date of publication of application: **18.02.2026**
(21) Application number: 24208792.2
(22) Date of filing: 24.10.2024
(51) Int. Cl.: H01L 21/56, H01L 23/31, H01L 23/552, H01L 25/065

(54) **METHOD OF MANUFACTURING FAN-OUT PACKAGING DEVICE AND FAN-OUT PACKAGING DEVICE MANUFACTURED THEREBY**

(30) Priority: 15.08.2024 KR 20240109475
(71) Applicant: Silicon Box Pte. Ltd., Singapore 529580 (SG)
(72) Inventor: SUTARDJA, Sehat, LAS VEGAS, 89109-1629 (US)
(74) Representative: Cabinet Beaumont

(57) **Abstract**

Disclosed is a method of manufacturing a fan-out packaging device, which is a method of manufacturing a packaging device using a wafer or panel level packaging process, the method including forming an additional GND layer on a part of a fan-out packaging substrate, forming a first dielectric layer having a first via hole on the additional GND layer, forming a redistribution layer (RDL) on the first dielectric layer and the first via hole, forming a second dielectric layer having a second via hole on the redistribution layer, and forming a bump structure on the second dielectric layer and the second via hole so as to be connected to the redistribution layer, wherein the additional GND layer is formed in directions toward four sides or at least two opposite sides of a die.

## Description

### BACKGROUND OF THE INVENTION

### 1. Field of the invention

The present invention relates to a method of manufacturing a fan-out packaging device and a fan-out packaging device manufactured thereby, and more particularly to a method of manufacturing a fan-out packaging device capable of providing a high-performance, high-reliability fan-out packaging device by forming an additional ground (GND) layer and a fan-out packaging device manufactured thereby.

### 2. Description of the Related Art

The so-called eight semiconductor processes are a wafer process, an oxidation process, a photolithography process, an etching process, a thin film process, a wiring process, a testing process, and a packaging process.

The present invention relates to the packaging process, which is one of the semiconductor processes. In general, a semiconductor packaging process includes wafer dicing, die attachment, die interconnection, molding, and packaging test steps.

In a conventional semiconductor packaging process, a wafer is cut and a packaging process is carried out, whereas in recent years, a "wafer level packaging (WLP)" process is carried out while a die is kept in a wafer state, which has the advantage of reducing the cost of package production compared to the conventional process by carrying out a packaging process and a test at one time in the wafer state and then cutting a chip.

In addition, research on a panel level packaging (PLP) process, which is superior to the wafer level packaging process, is also active, and this process has the advantage of further reducing production costs due to the larger number of dies that can be packaged compared to the WLP process.

Meanwhile, as semiconductor devices become highly integrated, high-performance, and miniaturized, various packaging technologies are evolving based on a wafer or panel level packaging method, and fan-in wafer or panel level packaging and fan-out wafer or panel level packaging technologies are being actively researched.

In particular, the fan-out wafer or panel level packaging (hereinafter referred to as fan-out wafer level packaging for convenience and also referred to as "fan-out WLP" or "FO-WLP" as needed) technology is a fan-out method of increasing the number of I/O pins, and has the advantage of being able to extend a wiring formation range beyond the area of a die by using a redistribution layer (RDL) process, thus securing a larger wiring formation surface relative to the size of the die.

In the fan-out wafer level packaging, the RDL process is performed to form a dielectric layer on the surface of the die, to form a wiring layer by copper plating, and to extend the wiring formation range beyond the die by repeatedly performing the above steps as needed.

That is, the RDL serves to optimize connection in the package by redistributing an input/output (I/O) signal pad of a chip. However, in environments with high wiring density, the disposition of the RDL becomes very complex, which may cause many problems during manufacturing. In particular, as the number of connections between chips increases, the wiring density of the RDL layer increases, which may degrade electrical performance and may increase manufacturing costs.

In addition, in order to improve the yield and contact resistance of the wiring layer by the RDL process, it is very important to improve the quality of a plating layer during a copper plating process.

Conventionally, attempts were made to slow the plating rate or to improve the plating process conditions in order to improve the quality of the plating layer, which reduces the process speed and cannot achieve process reproducibility.

In addition, when forming the RDL so as to have a plurality of layers, a dielectric layer is formed between the plating processes, and problems such as unevenness of the dielectric layer and deterioration of surface topology due to the deterioration of the quality of the plating layer occur, which ultimately leads to defects of a wiring layer by a subsequent RDL process. This leads to an increase in contact resistance or impedance, which has the disadvantage of low operating frequency.

### SUMMARY OF THE INVENTION

The present invention has been made in view of the above problems, and it is an object of the present invention to provide a method of manufacturing a fan-out packaging device capable of reducing the wiring density of a redistribution layer, improving electrical and mechanical reliability, increasing the plating rate and plating quality, and improving efficiency in a manufacturing process by forming an additional ground (GND) layer and a fan-out packaging device manufactured thereby.

In accordance with one aspect of the present invention, the above and other objects can be accomplished by the provision of a method of manufacturing a fan-out packaging device, which is a method of manufacturing a packaging device using a wafer or panel level packaging process, the method including forming an additional GND layer on a part of a fan-out packaging substrate, forming a first dielectric layer having a first via hole on the additional GND layer, forming a redistribution layer (RDL) on the first dielectric layer and the first via hole, forming a second dielectric layer having a second via hole on the redistribution layer, and forming a bump structure on the second dielectric layer and the second via hole so as to be connected to the redistribution layer, wherein the additional GND layer is formed in directions toward four sides or at least two opposite sides of a die.

In accordance with another aspect of the present invention, there is provided a fan-out packaging device, which is a packaging device using a wafer or panel level packaging process, the fan-out packaging device including a fan-out packaging substrate, an additional GND layer formed on a part of the fan-out packaging substrate, a first dielectric layer formed on the additional GND layer, the first dielectric layer including a first via hole, a redistribution layer (RDL) formed on the first dielectric layer and the first via hole, a second dielectric layer formed on the redistribution layer, the second dielectric layer including a second via hole formed by patterning, the second via hole being configured to expose a part of the redistribution layer, and a bump structure formed on the second dielectric layer and the second via hole, the bump structure being connected to the redistribution layer, wherein the additional GND layer is formed in directions toward four sides or at least two opposite sides of a die.

In addition, the additional GND layer according to the embodiment of the present invention may be electrically connected to a GND seal ring or a GND pad to provide a rebuilt GND seal ring or a rebuilt pad.

In addition, the additional GND layer may include a wiring line for die-to-die connection.

In addition, an insulating layer having an additional via hole may b formed between the fan-out packaging substrate and the additional GND layer.

In addition, the additional via hole may be connected to the GND pad and a signal pad by filling of the additional GND layer, whereby a pad rebuilt by the additional GND layer may be formed at the position of the additional via hole.

In addition, the additional via hole may b formed by applying a laser direct imaging method.

In addition, the insulating layer may be formed so as to have a thickness of 2 um or less.

In addition, a multiple redistribution layer/dielectric layer may be implemented by repeating the step of forming the first dielectric layer or the step of forming the redistribution layer.

In addition, the additional GND layer may b connected to each or all of GND planes formed at a subsequent redistribution layer.

In addition, in the step of forming the redistribution layer, a sealed type metal sealing ring may be formed around the edge of the fan-out packaging substrate to provide an additional conductor path.

In addition, the sealed type metal sealing ring may b connected to the additional GND layer via a vertical connection portion, or when a multiple redistribution layer/dielectric layer structure is formed, the sealed type metal sealing ring may be connected to a lower-layer sealed type metal sealing ring via the vertical connection portion and may be connected to the additional GND layer via the vertical connection portion.

### BRIEF DESCRIPTION OF THE DRAWINGS

FIGs. 1 and 2 are front schematic views showing a fan-out packaging device according to an embodiment of the present invention;
FIGs. 3 to 8 are side schematic views showing fan-out packaging devices according to various embodiments of the present invention; and
FIG. 9 is a schematic view showing the state in which a sealed type metal sealing ring is formed in accordance with an embodiment of the present invention.

### DETAILED DESCRIPTION OF THE PREFERRED EMBODIMENTS

The present invention relates to a method of manufacturing a fan-out packaging device and a fan-out packaging device manufactured thereby, wherein an additional ground (GND) layer is formed to reduce the wiring density of a redistribution layer, to improve electrical and mechanical reliability, to increase the plating rate and plating quality, and to improve efficiency in a manufacturing process.

Therefore, the present invention provides a high-performance, high-reliability fan-out packaging device in a fan-out packaging process.

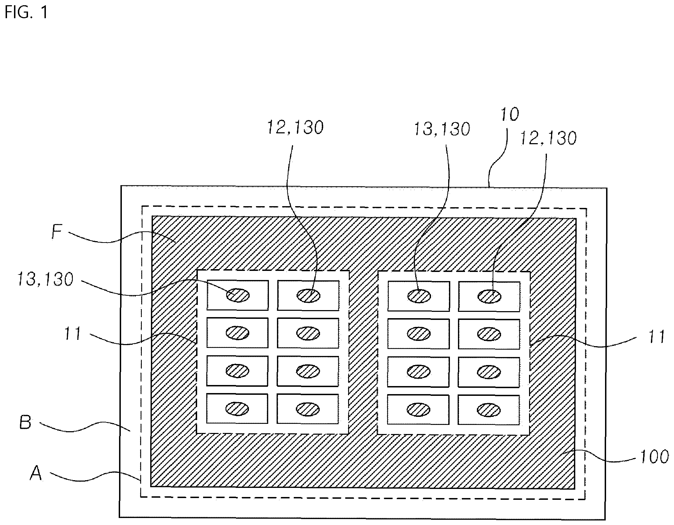

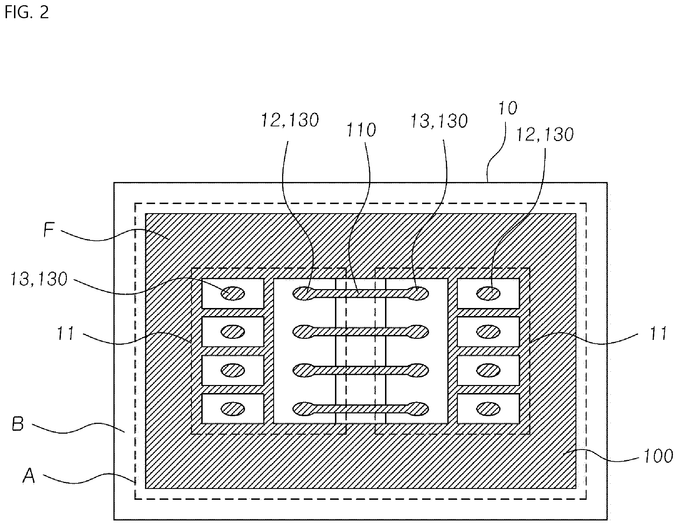

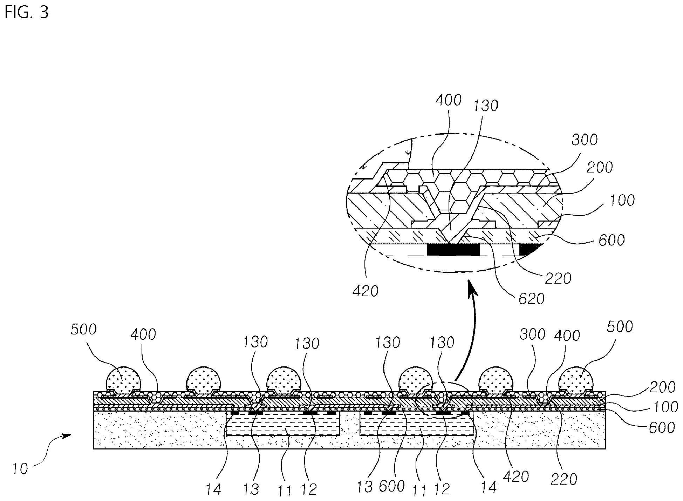

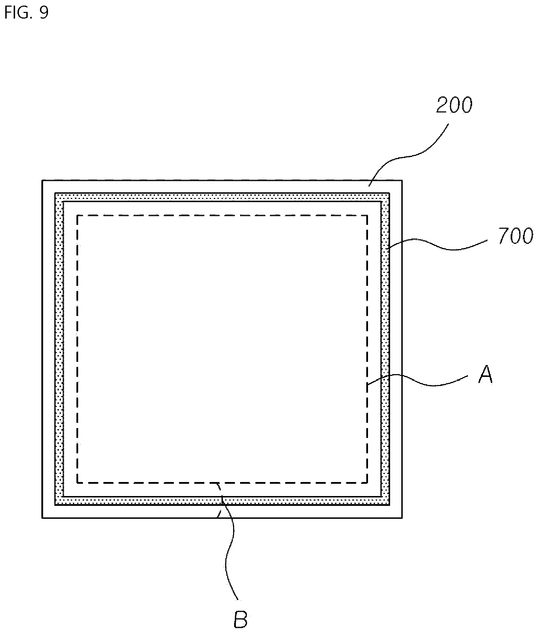

Hereinafter, embodiments of the present invention will be described in detail with reference to the accompanying drawings. FIGs. 1 and 2 are front schematic views showing a fan-out packaging device according to an embodiment of the present invention, FIGs. 3 to 8 are side schematic views showing fan-out packaging devices according to various embodiments of the present invention, and FIG. 9 is a schematic view showing the state in which a sealed type metal sealing ring is formed in accordance with an embodiment of the present invention.

As shown, a method of manufacturing a fan-out packaging device according to an embodiment of the present invention, which is a method of manufacturing a packaging device using a wafer or panel level packaging process, includes a step of forming an additional ground (GND) layer 100 on a part of a fan-out packaging substrate 10, a step of forming a first dielectric layer 200 having a first via hole 220 on the additional GND layer 100, a step of forming a redistribution layer (RDL) 300 on the first dielectric layer 200 and the first via hole 220, a step of forming a second dielectric layer 400 having a second via hole 420 on the redistribution layer 300, and a step of forming a bump structure 500 on the second dielectric layer 400 and the second via hole 420 so as to be connected to the redistribution layer 300, wherein the additional GND layer 100 is formed in directions toward four sides or at least two opposite sides of a die 11.

A fan-out packaging device according to an embodiment of the present invention manufactured by the method of manufacturing the fan-out packaging device, which is a packaging device using a wafer or panel level packaging process, includes a fan-out packaging substrate 10, an additional GND layer 100 formed on a part of the fan-out packaging substrate 10, a first dielectric layer 200 formed on the additional GND layer 100, the first dielectric layer including a first via hole 220, a redistribution layer (RDL) 300 formed on the first dielectric layer 200 and the first via hole 220, a second dielectric layer 400 formed on the redistribution layer 300, the second dielectric layer including a second via hole 420 formed by patterning, the second via hole being configured to expose a part of the redistribution layer 300, and a bump structure 500 formed on the second dielectric layer and the second via hole 420, the bump structure being connected to the redistribution layer 300, wherein the additional GND layer 100 is formed in directions toward four sides or at least two opposite sides of a die 11.

In the present invention, a packaging device is manufactured using a wafer or panel level packaging process, wherein, first, an additional GND layer 100 is formed on a part of a fan-out packaging substrate 10.

The fan-out packaging substrate 10 according to the embodiment of the present invention is a wafer or a substrate on which a single chip or a plurality of chip arrays is formed or is configured such that such a chip is diced, is disposed on a wafer or a panel by reconstitution, and is embedded using an epoxy molding compound (EMC). In the present invention, the terms "chip" and "die" 11 are used interchangeably.

As the result of implementing the embedded die 11 on the wafer or the panel, as described above, an input/output (I/O) signal pad 12 of the die 11 is exposed, the area other than the signal pad 12 may be provided after passivation, and the area outside the die 11 is provided as a fan-out area F.

In an embodiment of the present invention, an additional GND layer 100 is formed on a part of a fan-out packaging substrate 10 including an embedded die 11 by reconstitution on a wafer or a panel.

The additional GND layer 100 is formed on a part of the fan-out packaging substrate 10, and may be formed in directions toward four sides or at least two opposite sides of the die 11.

That is, the additional GND layer 100 is formed on the fan-out packaging substrate 10 in which the die 11 is embedded and from which the input/output (I/O) signal pad and a GND input/output (I/O) pad (GND pad) 13 of the die 11 are exposed upward, wherein the additional GND layer 100 is formed in directions toward four sides or is oppositely formed in directions toward at least two opposite sides of the die 11.

For example, if a single die 11 is embedded, the additional GND layer 100 may be formed in directions toward four sides or two opposite sides of the die 11, and if a plurality of dies 11 is embedded, the additional GND layer 100 may be formed in directions toward three sides of each die 11 and between the dies 11 (the remaining side).

FIG. 1 shows that, when two dies 11 are embedded, a GND layer is formed in directions toward three sides of each die 11 and between the dies 11 (the remaining side), and FIG. 2 shows that an additional GND layer 100 is formed in each of the two opposite side directions and a GND layer between the dies 11 is formed in the shape of a wiring line 110 for connection between the dies 11 (die-to-die connection).

That is, the additional GND layer 100 according to the present invention may be formed in a planar shape in the vicinity of the die 11 or, in a certain area, may be formed in the shape of a wiring line 110 for connection between the input and output signal pads 12 of the dies 11.

Generally, in fan-out packaging technology, the process of integrating several dies 11 into a single package results in a rapid increase in wiring density in the redistribution layer 300 as electrical connection between chips increases, which may lead to problems such as signal interference and power loss.

As the result of achieving the connection between the dies 11 via the additional GND layer 100 in the shape of the wiring line 110 according to the embodiment of the present invention, the wiring density of a subsequent redistribution layer 300 may be reduced, thereby securing wiring space and improving electrical performance.

In addition, as shown in FIGs. 1 and 2, the additional GND layer 100 is electrically connected to a GND seal ring 14 or a GND pad 13 to provide a rebuilt GND seal ring 120 or a rebuilt pad 130. That is, the additional GND layer 100 is formed on the GND seal ring 14 or the GND pad 13 to provide a rebuilt GND seal ring 120 or a rebuilt pad 130, which is electrically connected to a wiring line of a subsequent redistribution layer 300 to provide a GND seal ring 14 or a pad reconstituted by the redistribution layer 300.

In the present invention, as described above, more conductive paths that support an electroplating process are provided during the process of forming the redistribution layer 300 by forming the additional GND layer 100, which increases the plating rate and improves the quality of a plating layer (redistribution layer 300).

In addition, as the uniformity of the plating layer (redistribution layer 300) is ensured by the additional GND layer 100 according to the present invention, the uniformity of a dielectric layer and a redistribution layer 300 subsequently formed is secured, thereby reducing the defects of the redistribution layer 300. This effect is even more pronounced when a multiple redistribution layer 300 is formed.

In addition, the additional GND layer 100 according to the present invention ensures reproducibility and process stability of the electroplating process, which enables the process conditions to be kept constant, thus providing a plating layer with highly reproducible quality.

In addition, the additional GND layer 100 according to the present invention is formed as a wide plane at four sides or at least two opposite sides of the die 11 to enhance the overall stability of the packaging structure, thereby increasing the resistance to mechanical and thermal stresses.

In addition, the additional GND layer 100 according to the present invention allows heat to be efficiently dissipated, thereby improving the thermal management performance of a semiconductor apparatus and thus ensuring stable operation of a high-performance fan-out packaging apparatus.

Subsequently, a first dielectric layer 200 having a first via hole 220 is formed on the additional GND layer 100.

The first dielectric layer 200 according to the embodiment of the present invention is made of an organic or inorganic dielectric material, and may be made of a polymer material, such as polyimide, polybenzoxazole (PBO), or benzocyclobutene (BCB), or may be made of an inorganic material, such as an oxide or nitride. Preferably, silicon nitride or silicon oxide is used. In addition, as various embodiments, an oxide, such as SiO₂, SiOₓ, Al₂O₃, ZrO₂, or Ta₂O₅, or a nitride, such as SiNₓ, Si₃N₄, ZrN, AlN, BN, or TaN, may be used, and a mixture of two or more materials may be used as needed. In addition, the first dielectric layer may be made of the same kind of material as a second dielectric layer 400, a description of which will follow, or may be made of a different kind of material from the second dielectric layer.

The dielectric layer may be formed by a process, such as spin coating, chemical vapor deposition (CVD), sputtering, or lamination, or a combination thereof, and may be formed by an appropriate physical or chemical deposition process.

The first via hole 220 is formed by patterning the first dielectric layer 200. The first via hole 220 is formed by a patterning process and an etching process, and the first via hole 220 is filled with a metal to form an electrical connection passage between the upper and lower components.

A plurality of the first via holes 220 is formed in the first dielectric layer 200, whereby a part of the die 11 area and the fan-out area F or an active area A and an inactive area B is exposed. For example, the input/output (I/O) signal pad 12 and the GND pad 13 of the die 11 are exposed such that the signal pad 12 and the GND pad 13 are connected to the redistribution layer 300.

The first via hole 220 may be filled with various metal materials, such as aluminum (Al), tungsten (W), titanium (Ti), and copper (Cu), by sputtering, atomic layer deposition (ALD), CVD, or electroplating.

In the embodiment of the present invention, electroplating with good step coverage, low cost, and high productivity is used, and copper is used as the metal material.

Subsequently, a redistribution layer (RDL) 300 is formed on the first dielectric layer 200 and the first via hole 220, whereby the redistribution layer 300 is electrically connected to the signal pad 12 and the GND pad 13 of the die 11. The redistribution layer 300 is implemented by forming a metal layer on the first dielectric layer 200 during the process of filling the first via hole 220 with the metal material or after forming the first via hole 220 and forming a metallization pattern therefrom.

In the redistribution layer 300 according to the embodiment of the present invention, a copper layer is formed by electroplating, and a signal line for rearranging an electrical connection wire of the signal pad 12 or the GND pad 13 exposed from the die 11 is formed by a patterning process and an etching process thereof.

The redistribution layer 300 may be implemented as a single, multiple, or double-sided redistribution layer 300. That is, a multiple redistribution layer/dielectric layer is implemented by repeated formation of a dielectric layer and a metal layer (by repeating the first dielectric layer 200 formation process or the redistribution layer 300 formation process) to form a redistribution signal line to the fan-out area F.

When a multiple redistribution layer/dielectric layer is formed in accordance with an embodiment of the present invention, the additional GND layer 100 is connected to each or all of GND planes 15 formed at a subsequent redistribution layer 300 to provide an initial short circuit path, thereby optimizing electrical performance and increasing the reliability of signal transmission.

In the present invention, particularly in a process of forming the redistribution layer 300, a metal sealing ring 700 may be formed so as to be included in the redistribution layer 300.

The metal sealing ring 700 is formed by a simultaneous or continuous process in the process of forming the redistribution layer 300, and may be formed so as to be sealed (as a sealing ring) in a certain area on the fan-out packaging substrate 10, i.e., as a closed curved surface or a closed figure forming a closed circuit.

Preferably, the metal sealing ring is formed in a shape that surrounds the fan-out area F or surrounds the fan-out packaging substrate 10, i.e. in the active area A or the inactive area B, and may be formed as a double or triple closed circuit as needed. This provides a metal sealing ring 700 sealed in a certain area while avoiding overlap with an existing redistributed wiring circuit.

As the result of forming such a metal sealing ring 700, the reduced thickness of the dielectric layer formed at a wiring line of the redistribution layer or the edge of the pad is compensated for to provide a local planarization surface, thereby providing an electrical and structural planarization surface.

In addition, the sealed type metal sealing ring 700 according to the present invention extends the conductor path by providing an additional path for current to flow along with the seed layer, which reduces the overall resistance when the thickness of the seed layer increases, thereby increasing the efficiency of the electroplating process and helping to accelerate the plating rate. When current is evenly distributed and the conductor path is sufficient, therefore, uniformity of the plating thickness is also improved, resulting in a higher quality redistribution layer.

Particularly, in the wafer or panel level packaging process, the additional formation of the sealed type metal sealing ring 700 according to the present invention contributes to increase in the process speed and reduction in production costs, thereby reducing the overall package production costs.

Furthermore, in the case of forming a multiple redistribution layer 300, the sealed type metal sealing ring 700 according to the present invention prevents unevenness of the dielectric layer formed between the redistribution layers 300, whereby defects of a wiring layer in a subsequent redistribution layer 300 formation process may be reduced.

In addition, the sealed type metal sealing ring 700 according to the present invention is formed along the edge of the fan-out area F or the perimeter of the inactive area B, thereby enhancing the overall stability of the packaging structure to increase the resistance to mechanical and thermal stresses.

Furthermore, in such a multiple redistribution layer 300 structure, an initial short circuit path is provided by connecting a GND plane of each layer to the sealed type metal sealing ring 700, thereby optimizing electrical performance and increasing the reliability of signal transmission.

Subsequently, a second dielectric layer 400 having a second via hole 420 formed on the redistribution layer 300, and a bump structure 500 is formed on the second dielectric layer 400 and the second via hole 420 so as to be connected to the redistribution layer 300.

The second dielectric layer 400 is made of a material identical or similar to the material of the first dielectric layer 200 and is formed by a process identical or similar to the process by which the first dielectric layer 200 is formed, and is patterned to form the second via hole 420. The bump structure 500, which is connected to the redistribution layer 300, is formed on the second via hole 420.

In addition, according to the embodiment of the present invention, the first dielectric layer 200 formation process or the redistribution layer 300 formation process may be repeatedly performed to implement a multiple redistribution layer/dielectric layer.

That is, the redistribution layer 300 according to the embodiment of the present invention may be implemented as a single, multiple, or double-sided redistribution layer 300. That is, a multiple redistribution layer/dielectric layer is implemented by repeated formation of a dielectric layer and a metal layer (by repeating the first dielectric layer 200 formation process or the redistribution layer 300 formation process) to form a redistribution signal line to the fan-out area F.

When a multiple redistribution layer/dielectric layer is formed in accordance with an embodiment of the present invention, the additional GND layer 100 is connected to each or all of GND planes 15 formed at a subsequent redistribution layer 300 to provide an initial short circuit path, thereby optimizing electrical performance and increasing the reliability of signal transmission.

Furthermore, in the case of forming the multiple redistribution layer 300, the sealed type metal sealing ring 700 is formed in each redistribution layer 300, and the sealed type metal sealing rings 700 formed in the respective redistribution layer 300 are electrically connected to each other via a vertical connection portion 720, and are electrically connected to the additional GND layer 100 according to the present invention via the vertical connection portion 720. This provides an initial short circuit path, thereby optimizing electrical performance and increasing the reliability of signal transmission. Of course, even when forming a single redistribution layer 300, the sealed type metal sealing ring 700 is connected to the additional GND layer 100 via the vertical connection portion 720.

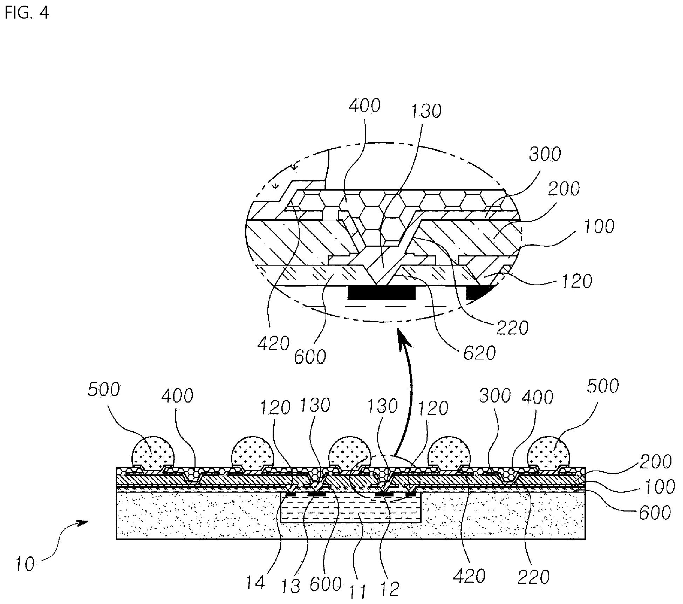

In the embodiments of FIGs. 1 to 3, a first dielectric layer 200 is formed on a fan-out packaging substrate 10 including two embedded dies 11, a redistribution layer 300 is formed on the first dielectric layer and a via hole thereof, a second dielectric layer 400 and a second via hole 420 are formed on the redistribution layer, and a bump structure 500 is formed on the second via hole 420 so as to be connected to the redistribution layer 300. In the embodiment of FIG. 2, the two embedded dies 11 are connected to each other via an additional GND layer 100 in the form of a wiring line 110. In the embodiments of FIGs. 4 to 8, the above structure is formed on a fan-out packaging substrate 10 including one embedded die 11.

In the bump structure 500 of the embodiment of the present invention, under bump metallization (UBM) (Ti/Cu layer deposition and patterning) is formed on the second via hole 420 formed in the second dielectric layer 400, and a solder bump is formed by solder plating, photoresist removal, unnecessary metal layer removal, and reflow. In the present invention, the solder bump and the UBM are referred to as the bump structure 500 for convenience.

After the solder bump is formed at the wafer or panel level, as described above, an additional or general packaging process may be performed, and dicing may be performed for division between fan-out packaging devices on a per-unit or per-module basis.

Meanwhile, according to the embodiment of the present invention, it is preferable to form an insulating layer 600 having an additional via hole 620 between the fan-out packaging substrate 10 and the additional GND layer 100.

The insulating layer 600 is thinly formed over the entire surface of the fan-out packaging substrate 10, wherein the additional via hole 620 is formed to expose a part of the die 11, and the signal pad 12, the GND pad 13, or the GND seal ring 14 of the die 11 is electrically connected to the redistribution layer 300 provided thereon via the additional via hole 620.

The insulating layer 600 according to the embodiment of the present invention is made of an organic or inorganic insulating material, and may be made of a polymer material, such as polyimide, polybenzoxazole (PBO), or benzocyclobutene (BCB), or may be made of an inorganic material, such as an oxide or nitride. Preferably, silicon nitride or silicon oxide is used. In addition, as various embodiments, an oxide, such as SiO₂, SiOₓ, Al₂O₃, ZrO₂, or Ta₂O₅, or a nitride, such as SiNₓ, Si₃N₄, ZrN, AlN, BN, or TaN, may be used, and a mixture of two or more materials may be used as needed.

The insulating layer 600 may be formed by a process, such as spin coating, chemical vapor deposition (CVD), sputtering, or lamination, or a combination thereof, and may be formed by an appropriate physical or chemical deposition process.

The insulating layer 600 is formed between the fan-out packaging substrate 10 and the additional GND layer 100, thereby providing electrical isolation between the fan-out packaging substrate 10 and the additional GND layer 100, and serving to mitigate the difference in properties between the surface of the fan-out packaging substrate 10 and the thin additional GND layer 100, i.e., the stress that occurs when the additional GND layer 100 is formed directly on the fan-out packaging substrate 10, which is mechanical stress. This increases the structural stability of the fan-out packaging device and ensures long-term reliability.

In addition, the insulating layer 600 is thinly formed so as to have a thickness of 2 um or less, whereby the size of a via may be reduced and the flatness in a subsequent process may be maintained.

The insulating layer 600 is patterned to form an additional via hole 620. The additional via hole 620 may be formed by a patterning process using basic photolithography, and the additional via hole 620 may be filled with metal by a separate metal filling process (such as a plating process) or simultaneously with the formation of the additional GND layer 100 to form a via, which becomes an electrical connection passage that connects the pad element of the die 11 and the like to the redistribution layer 300.

According to the embodiment of the present invention, the additional via hole 620 is connected to the GND pad 13 and the signal pad 12 by metal filling when the additional GND layer 100 is formed, whereby a pad 130 rebuilt by the additional GND layer 100 is formed at the position of the additional via hole 620.

Since the insulating layer 600 can be thinly formed so as to have a thickness of 2 um or less, a smaller via hole may be formed in the insulating layer 600, and the small via hole may be filled during a process of forming a subsequent metal layer (additional GND layer 100) to form a flat surface, and as a result, it is easier to stack vias in a subsequent dielectric layer.

In addition, the additional via hole 620 and the rebuilt GND seal ring 120 or the rebuilt pad 130 may be formed by applying a laser direct imaging method. This involves directly exposing a desired via pattern on the insulating layer 600 using a laser and selectively curing or removing the part where the via pattern is to be formed. The insulating layer 600 is then chemically or physically etched along the exposed pattern to form a via hole.

Here, the additional via hole 620 formed by etching is formed so as to precisely engage with the signal pad 12 or the GND pad 13 of the die 11, allowing for very precise control of the position and size of the via. That is, the additional via hole 620 of the insulating layer 600 is formed on the signal pad 12 and the GND pad 13 of the die 11, and is filled on the via hole of the insulating layer 600 to form the pad 130 rebuilt by the additional GND layer 100, whereby the position error of the die 11 may be compensated for. Furthermore, the reference may be applied when via holes are formed in the dielectric layer and the redistribution layer 300 formed on top thereof, thus improving the overall precision of via formation. This improves the accuracy of the electrical connection and secures reproducibility of the manufacturing process.

In addition, the thin insulating layer 600 formed on the fan-out substrate and the additional GND layer 100 according to the embodiment of the present invention enables the formation of a small via hole, which allows a planarization surface to be maintained after via hole filling. This also facilitates lamination of a subsequent metal layer (additional GND layer 100), thereby increasing the efficiency and reliability of the overall process.

Hereinafter, specific embodiments of the present invention will be described with reference to the accompanying drawings.

FIG. 1 shows that, when two dies 11 are embedded, a GND layer is formed in directions toward three sides of each die 11 and between the dies 11 (the remaining side), and FIG. 2 shows that an additional GND layer 100 is formed in each of the two opposite side directions and a GND layer between the dies 11 is formed in the shape of a wiring line 110 for connection between the dies 11 (die-to-die connection). FIG. 3 is a side schematic view of a fan-out packaging device when two dies 11 are embedded in accordance with an embodiment of the present invention.

That is, the additional GND layer 100 according to the present invention may be formed in a planar shape in the vicinity of the die 11 or, in a certain area, may be formed in the shape of a wiring line 110 for connection between the input and output signal pads 12 of the dies 11.

Generally, in fan-out packaging technology, the process of integrating several dies 11 into a single package results in a rapid increase in wiring density in the redistribution layer 300 as electrical connection between chips increases, which may lead to problems such as signal interference and power loss.

As the result of achieving the connection between the dies 11 via the additional GND layer 100 in the shape of the wiring line 110 according to the embodiment of the present invention, the wiring density of a subsequent redistribution layer 300 may be reduced, thereby securing wiring space and improving electrical performance.

In addition, as shown in FIGs. 1 to 3, the additional GND layer 100 is electrically connected to the GND seal ring 14 or the GND pad 13 to provide a rebuilt GND seal ring 120 or a rebuilt pad 130. That is, the additional GND layer 100 is formed on the GND seal ring 14 or the GND pad 13 to provide a rebuilt GND seal ring 120 or a rebuilt pad 130, which is electrically connected to a wiring line of a subsequent redistribution layer 300

In the present invention, as described above, more conductive paths that support an electroplating process are provided during the process of forming the redistribution layer 300 by forming the additional GND layer 100, which increases the plating rate and improves the quality of a plating layer (redistribution layer 300).

In addition, as the uniformity of the plating layer (redistribution layer 300) is ensured by the additional GND layer 100 according to the present invention, the uniformity of a dielectric layer and a redistribution layer 300 subsequently formed is secured, thereby reducing the defects of the redistribution layer 300. This effect is even more pronounced when a multiple redistribution layer 300 is formed.

In addition, the additional GND layer 100 according to the present invention ensures reproducibility and process stability of the electroplating process, which enables the process conditions to be kept constant, thus providing a plating layer with highly reproducible quality.

In addition, the additional GND layer 100 according to the present invention is formed as a wide plane at four sides or at least two opposite sides of the die 11 to enhance the overall stability of the packaging structure, thereby increasing the resistance to mechanical and thermal stresses.

FIGs. 4 to 8 are side schematic views showing fan-out packaging devices according to various embodiments of the present invention, and FIG. 9 is a schematic view showing the state in which a sealed type metal sealing ring 700 is formed in accordance with an embodiment of the present invention.

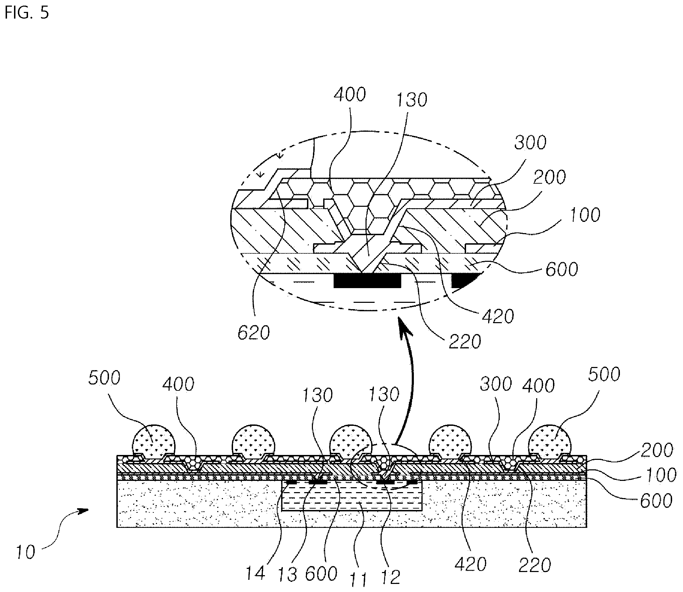

In FIGs. 4 and 5, an insulating layer 600 is formed on a fan-out packaging substrate 10 in accordance with an embodiment of the present invention, and an additional via hole 620 of the insulating layer 600 is filled while an additional GND layer 100 is formed, whereby a GND seal ring 120 and a GND pad 130 rebuilt by the additional GND layer 100 are provided respectively at positions of a GND seal ring 14 and a GND pad 13 of a die 11.

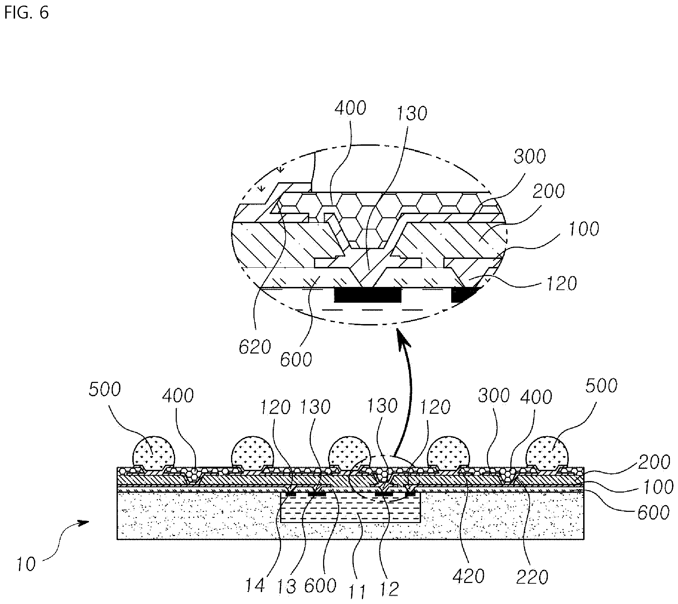

In FIG. 6, an insulating layer 600 is formed on a fan-out packaging substrate 10 in accordance with an embodiment of the present invention, and an additional via hole 620 of the insulating layer 600 is filled while an additional GND layer 100 is formed, whereby a GND seal ring 120 and a GND pad 130 rebuilt by the additional GND layer 100 are provided respectively at positions of a GND seal ring 14 and a GND pad 13 of a die 11.

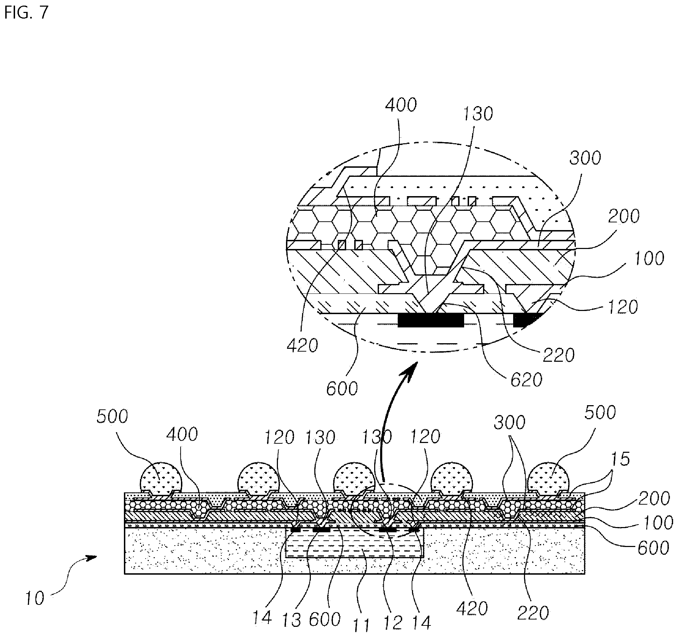

In FIG. 7, an insulating layer 600 is formed on a fan-out packaging substrate 10 in accordance with an embodiment of the present invention, and an additional via hole 620 of the insulating layer 600 is filled while an additional GND layer 100 is formed, whereby a GND seal ring 120 and a GND pad 130 rebuilt by the additional GND layer 100 are provided respectively at positions of a GND seal ring 14 and a GND pad 13 of a die 11, wherein a multiple redistribution layer 300 is formed.

In FIG. 7, the additional GND layer 100 is connected to each or all of GND planes 15 formed at a subsequent redistribution layer 300 to provide an initial short circuit path, thereby optimizing electrical performance and increasing the reliability of signal transmission.

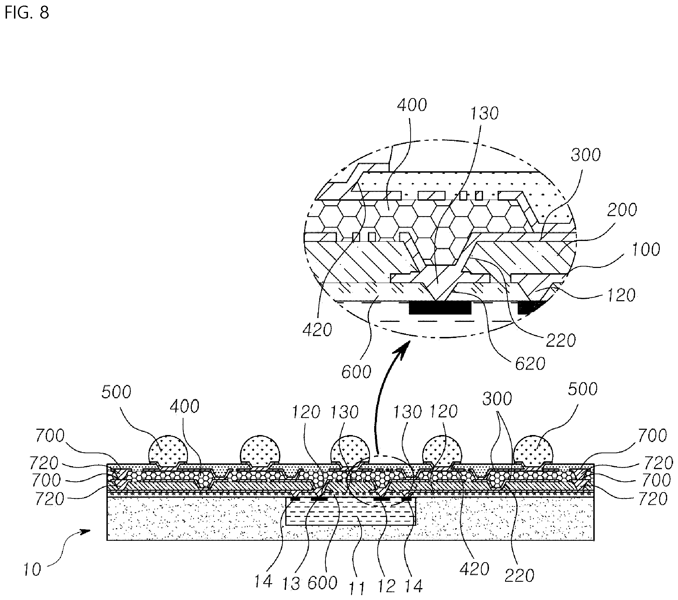

In FIG. 8, an insulating layer 600 is formed on a fan-out packaging substrate 10 in accordance with an embodiment of the present invention, and an additional via hole 620 of the insulating layer 600 is filled while an additional GND layer 100 is formed, whereby a GND seal ring 120 and a GND pad 130 rebuilt by the additional GND layer 100 are provided respectively at positions of a GND seal ring 14 and a GND pad 13 of a die 11, wherein a multiple redistribution layer 300 is formed. In particular, a metal sealing ring 700 is formed so as to be included in the redistribution layer 300 in the process of forming the redistribution layer 300.

The metal sealing ring 700 is formed by a simultaneous or continuous process in the process of forming the redistribution layer 300, and may be formed so as to be sealed (as a sealing ring) in a certain area on the fan-out packaging substrate 10, i.e., as a closed curved surface or a closed figure forming a closed circuit.

Preferably, the metal sealing ring is formed in a shape that surrounds the fan-out area F or surrounds the fan-out packaging substrate 10, i.e. in the active area A or the inactive area B, and may be formed as a double or triple closed circuit as needed. This provides a metal sealing ring 700 sealed in a certain area while avoiding overlap with an existing redistributed wiring circuit. FIGs. 8 and 9 a metal sealing ring 700 formed in the inactive area B so as to surround the fan-out packaging substrate 10.

As the result of forming such a metal sealing ring 700, the reduced thickness of the dielectric layer formed at a wiring line of the redistribution layer 300 or the edge of the pad is compensated for to provide a local planarization surface, thereby providing an electrical and structural planarization surface.

In addition, the sealed type metal sealing ring 700 according to the present invention extends the conductor path by providing an additional path for current to flow along with the seed layer, which reduces the overall resistance when the thickness of the seed layer increases, thereby increasing the efficiency of the electroplating process and helping to accelerate the plating rate. When current is evenly distributed and the conductor path is sufficient, therefore, uniformity of the plating thickness is also improved, resulting in a higher quality redistribution layer 300.

Particularly, in the wafer or panel level packaging process, the additional formation of the sealed type metal sealing ring according to the present invention contributes to increasing the process speed, reducing production costs, and thus reducing the overall package production costs.

Furthermore, in the case of forming a multiple redistribution layer, the sealed type metal sealing ring according to the present invention prevents unevenness of the dielectric layer formed between the redistribution layers, whereby defects of a wiring layer in a subsequent redistribution layer formation process may be reduced.

In addition, the sealed type metal sealing ring according to the present invention is formed along the edge of the fan-out area or the perimeter of the inactive area, thereby enhancing the overall stability of the packaging structure to increase the resistance to mechanical and thermal stresses.

Furthermore, in such a multiple redistribution layer structure, an initial short circuit path is provided by connecting a GND plane of each layer to the sealed type metal sealing ring, thereby optimizing electrical performance and increasing the reliability of signal transmission.

As is apparent from the above description, in a fan-out packaging device according to an embodiment of the present invention, an additional GND layer is formed to provide an additional conductor path during a redistribution layer formation process, thereby improving the plating rate and ensuring the uniformity of a plating layer (redistribution layer). Consequently, the uniformity of a dielectric layer and a redistribution layer subsequently formed is secured, thereby reducing the defects of the redistribution layer. This effect is even more pronounced when a multiple redistribution layer 300 is formed. This is more useful in the case of forming a multiple redistribution layer.

In addition, the additional GND layer according to the present invention ensures reproducibility and process stability of an electroplating process, which enables the process conditions to be kept constant, thus providing a plating layer with highly reproducible quality (redistribution layer).

In addition, the additional GND layer according to the present invention is formed as a wide plane at four sides or at least two opposite sides of a die to enhance the overall stability of the packaging structure, thereby increasing the resistance to mechanical and thermal stresses.

In addition, the additional GND layer according to the present invention allows heat to be efficiently dissipated, thereby improving the thermal management performance of a semiconductor apparatus and thus ensuring stable operation of a high-performance fan-out packaging apparatus.

Furthermore, in the fan-out packaged device according to the embodiment of the present invention, a metal sealing ring is formed, whereby it is possible to improve local planarization, to extend the conductor path, and to increase the efficiency of the electroplating process.

Furthermore, in the embodiment of the present invention, an insulating layer is formed between a fan-out packaging substrate and the additional GND layer, thereby providing electrical isolation between the fan-out packaging substrate and the additional GND layer, and serving to mitigate the difference in properties between the surface of the fan-out packaging substrate and the thin additional GND layer, i.e., the stress that occurs when the additional GND layer is formed directly on the fan-out packaging substrate, which is mechanical stress. This increases the structural stability of the fan-out packaging device and ensures long-term reliability.

In addition, an additional via hole of the insulating layer formed according to the embodiment of the present invention is formed on a signal pad and a GND pad of the die, and is filled on a via hole of the insulating layer to form a pad rebuilt by the additional GND layer, whereby the position error of the die may be compensated for. Furthermore, the reference may be applied when via holes are formed in a dielectric layer and a redistribution layer 300 formed on top thereof, thus improving the overall precision of via formation. This improves the accuracy of the electrical connection and secures the reproducibility of the manufacturing process.

In addition, the thin insulating layer formed on the fan-out substrate and the additional GND layer according to the embodiment of the present invention enables the formation of a small via hole, which allows a planarization surface to be maintained after via hole filling. This also facilitates lamination of a subsequent metal layer (additional GND layer), thereby increasing the efficiency and reliability of the overall process.

## Claims

1. A method of manufacturing a fan-out packaging device, which is a method of manufacturing a packaging device using a wafer or panel level packaging process, the method comprising:
forming an additional ground (GND) layer on a part of a fan-out packaging substrate;
forming a first dielectric layer having a first via hole on the additional GND layer;
forming a redistribution layer (RDL) on the first dielectric layer and the first via hole;
forming a second dielectric layer having a second via hole on the redistribution layer; and
forming a bump structure on the second dielectric layer and the second via hole so as to be connected to the redistribution layer, wherein
the additional GND layer is formed in directions toward four sides or at least two opposite sides of a die.

2. The method according to claim 1, wherein the additional GND layer is electrically connected to a GND seal ring or a GND pad to provide a rebuilt GND seal ring or a rebuilt pad.

3. The method according to claim 1, wherein the additional GND layer comprises a wiring line for die-to-die connection.

4. The method according to claim 1, wherein an insulating layer having an additional via hole is formed between the fan-out packaging substrate and the additional GND layer.

5. The method according to claim 4, wherein the additional via hole is connected to a GND pad and a signal pad by filling of the additional GND layer, whereby a pad rebuilt by the additional GND layer is formed at a position of the additional via hole.

6. The method according to claim 5, wherein the additional via hole is formed by applying a laser direct imaging method.

7. The method according to claim 4, wherein the insulating layer is formed so as to have a thickness of 2 um or less.

8. The method according to claim 1, wherein a multiple redistribution layer/dielectric layer is implemented by repeating the step of forming the first dielectric layer or the step of forming the redistribution layer.

9. The method according to claim 8, wherein the additional GND layer is connected to each or all of GND planes formed at a subsequent redistribution layer.

10. The method according to claim 1, wherein, in the step of forming the redistribution layer, a sealed type metal sealing ring is formed around an edge of the fan-out packaging substrate to provide an additional conductor path.

11. The method according to claim 10, wherein
the sealed type metal sealing ring is connected to the additional GND layer via a vertical connection portion, or
when a multiple redistribution layer/dielectric layer structure is formed, the sealed type metal sealing ring is connected to a lower-layer sealed type metal sealing ring via the vertical connection portion and is connected to the additional GND layer via the vertical connection portion.

12. A fan-out packaging device, which is a packaging device using a wafer or panel level packaging process, the fan-out packaging device comprising:
a fan-out packaging substrate;
an additional GND layer formed on a part of the fan-out packaging substrate;
a first dielectric layer formed on the additional GND layer, the first dielectric layer comprising a first via hole;
a redistribution layer (RDL) formed on the first dielectric layer and the first via hole;
a second dielectric layer formed on the redistribution layer, the second dielectric layer comprising a second via hole formed by patterning, the second via hole being configured to expose a part of the redistribution layer; and
a bump structure formed on the second dielectric layer and the second via hole, the bump structure being connected to the redistribution layer, wherein
the additional GND layer is formed in directions toward four sides or at least two opposite sides of a die.

13. The fan-out packaging device according to claim 12, wherein the additional GND layer is electrically connected to a GND seal ring or a GND pad to provide a rebuilt GND seal ring or a rebuilt pad.

14. The fan-out packaging device according to claim 12, wherein the additional GND layer comprises a wiring line for die-to-die connection.

15. The fan-out packaging device according to claim 12, wherein an insulating layer comprising an additional via hole is formed between the fan-out packaging substrate and the additional GND layer.
